# EUROPÄISCHE PATENTANMELDUNG

(11) **EP 2 763 397 A1**
(43) Veröffentlichungstag der Anmeldung: **06.08.2014**
(21) Anmeldenummer: 13154046.0
(22) Anmeldetag: 05.02.2013
(51) Int. Cl.: H04N 5/33, H04N 9/04, G07C 9/00, H01L 27/146

(54) **Fotosensor**

(71) Anmelder: BURG-WÄCHTER KG, 58540 Meinerzhagen (DE)
(72) Erfinder: Wiling, Harald, 58540 Meinerzhagen (DE)
(74) Vertreter: Stenger, Watzke & Ring

(57) **Zusammenfassung**

Fotosensor mit einer Sensormatrix aus lichtsensitiven Pixeln, und mit einer in Einstrahlrichtung des Lichtes davor angeordneten Filtermatrix, welche zu den Pixeln der Sensormatrix korrespondierend angeordnete, jeweils entweder selektiv rotes, grünes oder blaues Licht transmittierende Spektralfilter (R, G, B) aufweist, und wobei die Spektralfilter (R, G, B) innerhalb der Filtermatrix ein wiederkehrendes Muster bilden. Um einen solchen Fotosensor auch ausschließlich zur Detektion von Infrarotlicht verwenden zu können, beispielsweise für die optische Gesichtsfelderkennung, schlägt die Erfindung vor, dass die Filtermatrix zusätzlich Infrarotfilter (1) aufweist, welche so ausgebildet sind, dass sie infrarotes Licht transmittieren und gleichzeitig sichtbares Licht sperren.

## Beschreibung

Die Erfindung betrifft einen Fotosensor mit einer Sensormatrix aus lichtsensitiven Pixeln, und mit einer in Einstrahlrichtung des Lichtes davor angeordneten Filtermatrix, welche zu den Pixeln der Sensormatrix korrespondierend angeordnete, jeweils entweder selektiv rotes, grünes oder blaues Licht transmittierende Spektralfilter aufweist, und wobei die Spektralfilter innerhalb der Filtermatrix ein wiederkehrendes Muster bilden.

Fotosensoren der vorgenannten Art werden seit langer Zeit in Digitalkameras eingesetzt. Der Fotosensor ist dabei meistens ein CCD- oder CMOS-Chip. Da diese aus Halbleitern hergestellten Sensoren lediglich die Lichtintensität und nicht die Wellenlänge des Lichtes messen können, werden einzelne Pixel des Sensors mit wellenlängenselektiven Filtern versehen. Durch diese wird das auf den Sensor einstrahlende Licht in seinen grünen, roten und blauen Bestandteil zerlegt, einzeln auf dem Chip abgetastet und für die spätere Bilddarstellung wieder zusammengeführt. Da das menschliche Auge grüne Farbtöne besser wahrnehmen kann als beispielsweise rote oder blaue, sind die im Stand der Technik bekannten Sensoren meistens so ausgebildet, dass sie doppelt so viele Pixel für die Detektion des grünen Lichtanteils aufweisen wie Pixel für die Detektion der roten oder blauen Lichtanteile.

Besonders bekannt und verbreitet sind die sogenannten Bayer-Sensoren (US-Patent 3,971,065), deren Pixelmatrix mit einem Farbfilter, ähnlich einem Schachbrettmuster, überzogen ist. Dieser Farbfilter besteht zu 50% aus grünes Licht transmittierenden Spektralfiltern und zu je 25% aus rotes beziehungsweise blaues Licht transmittierenden Spektralfiltern. Grün ist in der Flächenzuweisung und somit auch in der Auflösungsfähigkeit des Sensors privilegiert, da der grüne Spektralanteil des Lichtes im menschlichen Auge den größten Beitrag zur Helligkeitswahrnehmung und somit auch zur Kontrast- und Schärfewahrnehmung leistet. Insgesamt erfolgt die Helligkeitsbeziehungsweise Kontrastwahrnehmung des menschlichen Auges zu 72% über Grünanteile des Lichtes, während dagegen die roten Spektralanteile lediglich 21 % und die blauen Spektralanteile lediglich 7% Beitrag leisten. Die lichtempfindlichen Pixel eines Halbleitersensors, wie dem Bayer-Sensor, können nur Helligkeitswerte erfassen. Um Farbinformationen zu erhalten, wird vor jedem einzelnen Pixel ein Farbfilter in einer der drei Grundfarben rot, grün oder blau aufgebracht. Die Filter sind dabei beispielsweise in den ungeraden Zeilen in der Folge grün-rot und in den graden Zeilen in der Folge blaugrün aufgebracht. Jedes Pixel liefert somit nur Informationen für eine einzige Farbkomponente, so dass für ein vollständiges Bild die jeweils benachbarten Pixel derselben Farbe zur Farbinterpolation herangezogen werden müssen. Dafür werden die Pixel gleicher Farbe mithilfe eines speziellen Algorithmus nacheinander so ausgelesen, dass sich die Helligkeitswerte der gleichen Farbanteile aufsummieren. Je nach der besonderen Anordnung der grünen, roten und blauen Pixel innerhalb des Sensors ist somit ein anderer Algorithmus zum Auslesen der Helligkeitswerte erforderlich.

Neben den vorgenannten, üblichen Bayer-Sensoren existieren ebenfalls modifizierte Varianten, welche zusätzlich auch die Detektion von Infrarotlicht zulassen. Die US 2007/0145273 A1 offenbart beispielsweise einen in Bezug auf die Lichtausbeute verbesserten Kamerachip, bei welchem gegenüber dem üblichen Aufbau eines Bayer-Sensors ein mit einem Grünfilter belegtes Pixel ausgetauscht ist durch ein sogenanntes transparentes Pixel, welches keinerlei Filter aufweist und somit sowohl sichtbares als auch infrarotes Licht detektiert. Dadurch wird insgesamt die auf den Sensor fallende Lichtmenge erhöht, was insgesamt zu einem verbesserten Kontrast und einer verbesserten Bildschärfe führt. Jedoch wird die Helligkeit zu Ungunsten der Detektion des Grünanteils des Lichtes verbessert. Dies führt insgesamt zu einer Farbverfälschung des Bildes und muss dementsprechend zum Ausgleich mit Hilfe mathematischer Methoden korrigiert werden.

Obwohl mit den vorgenannten Sensoren durchaus eine zufriedenstellende Farbaufnahme bei gewöhnlichen Digitalkameras erreicht wird, sind dennoch im Hinblick auf spezielle Anwendungsbereiche, insbesondere die optische Gesichtsfelderkennung mit Infrarotlicht, Verbesserungen gewünscht.

Insbesondere im Bereich der Gesichtsfelderkennung, vor allem für die Ermittlung einer Zutrittsberechtigung eines Nutzers zu einem Gebäude oder dergleichen und zum automatischen Öffnen eines Türschlosses ist es gewünscht, dass ein Fotosensor bei unterschiedlichen Lichtbedingungen, das heißt beispielsweise sowohl bei Tag als auch bei Nacht zuverlässig nicht nur ein Bild aufnimmt, sondern dieses Bild darüber hinaus auch so hohe Qualität in Bezug auf Schärfe und Helligkeit aufweist, dass eine Person zuverlässig erkannt werden kann und somit nicht unbefugten Personen Zutritt zu dem geschützten Gebäude gewährt wird. Mittels seiner biometrischen Merkmale wird der Nutzer eindeutig identifiziert. Neben den häufig genutzten Fingerabdrücken sind dabei auch die Merkmale des Gesichtes nahezu einzigartig, so dass in der Regel die Merkmale des Gesichtsfeldes, sofern sie bekannt sind, einer Person als Identifikationselemente zugeordnet werden können. Zur Ermittlung der Zutrittsberechtigung werden die biometrischen Merkmale des Nutzers, mit einer Vielzahl von in einem Speicher gespeicherten Daten unterschiedlicher Nutzer verglichen. Bei der Gesichtsfelderkennung kommen sowohl zweidimensionale als auch dreidimensionale Verfahren zur Anwendung. Bei den zweidimensionalen Gesichtsfelderkennungsverfahren werden anhand der mit dem Fotosensor aufgenommenen Bilddaten besondere geometrische Merkmale des Gesichtes vermessen. Dies können beispielsweise der Abstand, die Größe und Position der Augen, der Nase und des Mundes sein. Sofern die Vorrichtung zur Ermittlung der Zutrittsberechtigung ein detektiertes Bild als zu einem autorisierten Nutzer gehörend identifiziert, wird ein Türschloss freigegeben. Der Nutzer kann somit den geschützten Bereich betreten.

Neben den zuvor genannten Bayer-Sensoren existiert im Stand der Technik eine weitere Art von Fotosensoren, mit deren Hilfe das Licht in seinen roten, grünen und blauen Spektralanteil zerlegt werden kann. Bei diesen Fotosensoren sind die Sensorelemente zur Detektierung der unterschiedlich farbigen Lichtanteile nicht nebeneinander angeordnet, sondern in Einstrahlrichtung des Lichtes hintereinander. Somit können alle drei Grundfarben des Lichtes mit jedem Pixel aufgezeichnet werden. Einen solchen Fotosensor zeigt beispielsweise die Patentschrift US 6,632,701 B2. Dieser Sensor besteht aus einem Silizium-Substrat, welches in drei verschiedene in Einstrahlrichtung des Lichtes hintereinander liegende Zonen aufgeteilt ist. Eine erste Zone ist dabei in einem solchen Abstand zu der bestrahlten Oberfläche der Sensormatrix angeordnet, dass der Abstand im Wesentlichen der Absorptionslänge in Silizium der ersten Lichtwellenlänge, das heißt des blauen Lichtes, entspricht. Eine zweite Zone ist in einem Abstand von der Oberfläche der Sensormatrix angeordnet, welcher der Absorptionslänge des grünen Lichtes entspricht.

Die dritte Zone schließlich ist in einem Abstand von der Oberfläche der Sensormatrix angeordnet, welcher der Absorptionslänge des roten Lichtes entspricht. Dabei nutzt dieser Sensor den physikalischen Effekt, dass unterschiedliche Wellenlängen in unterschiedlichen Schichten der Sensormatrix absorbiert werden, da langwelliges Licht in Silizium eine größere Eindringtiefe hat als kurzwelliges Licht. Sofern an der Oberfläche der Sensormatrix ein Infrarot-Sperrfilter angeordnet wird, kann das Infrarotlicht nicht mehr in den Sensor eindringen und es ergeben sich Farbempfindlichkeiten, die den Empfindlichkeiten des menschlichen Auges ähnlich sind.

Besonders im Bezug auf den vorgenannten Anwendungsbereich, nämlich die Ermittlung einer Zutrittsberechtigung durch eine Vorrichtung zur optischen Gesichtsfelderkennung, bestehen bei den bekannten Fotosensoren Nachteile darin, dass sie ausschließlich bei Tageslicht zufriedenstellende Bilddetektion ermöglichen, während die Detektion bei Nacht mittels Infrarotlicht keine zufriedenstellenden Ergebnisse liefert.

Daher ist es Aufgabe der Erfindung, einen vorbeschriebenen Fotosensor zu entwickeln, welcher sowohl sichtbares als auch infrarotes Licht in unterschiedlichen Belichtungssituationen zuverlässig detektieren kann und somit für den Einsatz in einer Vorrichtung zur Ermittlung einer Zutrittsberechtigung mittels optischer Gesichtsfelderkennung geeignet ist.

Die vorgenannte Aufgabe wird mit einem Fotosensor der vorbekannten Art gelöst, dessen Filtermatrix zusätzlich Infrarotfilter aufweist, welche so ausgebildet sind, dass sie infrarotes Licht transmittieren und gleichzeitig sichtbares Licht sperren.

Somit weist die Filtermatrix des erfindungsgemäßen Fotosensors für jedes Pixel der Sensormatrix einen Filter auf, welcher ganz selektiv lediglich einen spektralen Teilbereich des Lichtes transmittiert. Dabei existieren sowohl Spektralfilter, welche selektiv nur grünes, rotes oder blaues Licht durchlassen, als auch Infrarotfilter, welche lediglich Infrarotlicht, nämlich insbesondere solches im sogenannten "nahen Infrarot" durchlassen, dessen Wellenlängenbereich sich unmittelbar an den des sichtbaren Lichtes anschließt. Somit fällt auf jedes Pixel der Sensormatrix lediglich eine ganz klar definierte Wellenlänge, beziehungsweise ein klar definierter Ausschnitt des Lichtspektrums, so dass kein Pixel gleichzeitig von sichtbarem als auch infrarotem Licht bestrahlt wird. Dadurch kann ganz gezielt eine Ansteuerung der Pixel der Sensormatrix dahingehend erfolgen, dass bei einem Tagbetrieb des Fotosensors lediglich die mit grünem, rotem und blauem Licht beleuchten Pixel ausgelesen werden, während für einen Nachtbetrieb des Fotosensors nur die Infrarotlicht detektierenden Pixel angesteuert werden. Somit ist es durch einfache Abwandlung der vorbekannten Fotosensoren und mit entsprechend dazu ausgebildetem Ansteuerungsalgorithmus für die Sensormatrix möglich, ein und denselben Fotosensor für unterschiedliche Lichtbedingungen zu verwenden. Eine Verwendung unterschiedlicher Fotosensoren oder gar unterschiedlicher Vorrichtungen zur optischen Gesichtsfelderkennung ist somit überflüssig. Ebenfalls ist es durch die integrierte Anordnung von Sensormatrix und dazu korrespondierender Filtermatrix innerhalb ein und desselben Fotosensors möglich, dass vorgeschaltete, separate Filter für infrarotes oder sichtbares Licht entfallen.

Vorteilhaft sind die jeweils entweder grünes, rotes oder blaues Licht transmittierenden Spektralfilter innerhalb des Fotosensors im Wesentlichen regelmäßig so angeordnet, dass sie innerhalb der Filtermatrix wiederkehrende Blöcke bilden. Beispielsweise können dabei jeweils zwei grüne Spektralfilter, ein roter Spektralfilter und ein blauer Spektralfilter zu einem Block angeordnet sein. Hierdurch wird dem Umstand Rechnung getragen, dass die grünen Anteile des Lichtspektrums vom menschlichen Auge besser wahrnehmbar sind als andere Lichtanteile. Somit lässt sich ein Objekt unmittelbar bei der Aufnahme so detektieren, wie es auch das menschliche Auge wahrnimmt.

Die Erfindung sieht vor, dass die Infrarotfilter innerhalb der Filtermatrix eine regelmäßige Anordnung aufweisen. Durch die regelmäßige Anordnung der Infrarotfilter innerhalb der übrigen Filter für das grüne, rote und blaue Licht wird erreicht, dass die entsprechenden Pixel besonders leicht mittels des Algorithmus ansteuerbar sind und ebenso auch mit immer gleichbleibender Dichte auf dem Fotosensor vertreten sind, so dass über die gesamte Fläche des Fotosensors eine gleichgute Infrarotdetektion möglich ist.

Besonders einfach ist der Fotosensor dann ausgebildet, wenn die Anordnung der Infrarotfilter so erfolgt, dass die Infrarotfilter Blöcke aus grünes, rotes und blaues Licht transmittierenden Spektralfiltern begrenzen. Somit ist stets eine bestimmte Anzahl von grünen, roten und blauen Spektralfiltern, welche die vorgenannten Blöcke bilden, von einer immer gleichen Anzahl von Infrarotfiltern umgeben. Das stöchiometrische Verhältnis zwischen Infrarotfiltern und Spektralfiltern für das grüne, rote und blaue Licht bleibt somit über den gesamten Fotosensor gleich.

Die Erfindung schlägt als besonders vorteilhaft eine Anordnung der Infrarotfilter vor, welche eine Anordnung aus parallelen Zeilen oder Spalten aufweist. Darüber hinaus ist auch eine Anordnung besonders geeignet, bei welcher die Infrarotfilter innerhalb der Filtermatrix eine Gitterstruktur aus sich kreuzenden Zeilen und Spalten bilden. Somit kann grundsätzlich die übliche Bayer-Struktur des Fotosensors erhalten bleiben, wobei jeweils zwei grüne, ein roter und ein blauer Spektralfilter zu einem quadratischen Block angeordnet sind. Diese Blöcke sind dann jeweils von der Gitterstruktur der Infrarotfilter umgeben, so dass die Blöcke von Zeilen und/oder Spalten aus Infrarotfiltern begrenzt sind.

Alternativ ist es jedoch auch möglich, dass jeweils ein grünes, ein rotes und ein blaues Licht transmittierender Spektralfilter sowie ein Infrarotfilter zu einem Block angeordnet sind. Dabei ist in der üblichen Bayer-Struktur jeweils ein "grünes Spektralfilter" innerhalb des Blockes durch ein Infrarotfilter ersetzt. Dadurch ergibt sich jeweils ein Block aus einem grünen, einem roten, einem blauen und einem infraroten Filter. Auch diese Anordnung ist besonders einfach zu realisieren, jedoch muss bedacht werden, dass diese Anordnung die Helligkeits- und Kontrastwahrnehmung der Grüntöne im Gegensatz zu einem herkömmlichen Bayer-Sensor verschlechtert. Daher muss der Auswertealgorithmus den Grünanteil mit einem entsprechenden Faktor gewichten.

In Bezug auf den alternativen Fotosensor, welcher eine Sensormatrix mit mehreren in Einstrahlrichtung des Lichtes hintereinander angeordneten Sensorelementen aufweist, wird die der Erfindung zugrundeliegende Aufgabe dadurch gelöst, dass in Einstrahlrichtung des Lichtes vor der Sensormatrix eine Filtermatrix angeordnet ist, welche zu einer Teilmenge von Pixeln der Sensormatrix korrespondierend angeordnete Infrarotfilter aufweist, welche so ausgebildet sind, dass sie infrarotes Licht transmittieren und gleichzeitig sichtbares Licht sperren. Dadurch weist der Fotosensor ganz gezielt Bereiche der Sensormatrix auf, welche ausschließlich von infrarotem Licht bestrahlt werden, wobei das infrarote Licht sodann in den Bereich des rotes Licht absorbierenden Sensorelementes gelangt und dort ausgelesen werden kann. Andere Bereiche, das heißt andere Pixel, der Sensormatrix liegen dagegen in Einstrahlrichtung des Lichtes nicht hinter einem Infrarotfilter, so dass alle Lichtwellenlängen, nämlich sowohl das sichtbare Licht als auch das infrarote Licht, in die hintereinander angeordneten Sensorelemente eindringen können, um dort in dem mit der Wellenlänge korrespondierenden Sensorelement absorbiert zu werden. Beim Auslesen der Infrarot-Anteile werden dann ganz gezielt lediglich die Pixel angesteuert, welche mit einem Infrarotfilter belegt sind, während für das Auslesen der Rot-, Grün- beziehungsweise Blauanteile des Lichtes diejenigen Pixel angesteuert werden, welche keinen Infrarotfilter aufweisen.

Zusätzlich kann vorgesehen sein, dass die Sensormatrix in Einstrahlrichtung hinter den blaues, grünes und rotes Licht absorbierenden Sensorelementen ein zusätzliches Sensorelement aufweist, welches infrarotes Licht absorbiert, wobei das infrarotes Licht absorbierende Sensorelement mit einem Abstand zu der bestrahlten Oberfläche angeordnet ist, welcher im Wesentlichen der Absorptionslänge der Lichtwellenlängen des nahinfraroten Spektralbereichs entspricht.

Der vorgenannte Fotosensor mit vier hintereinander angeordneten Sensorelementen für blaues, grünes, rotes und infrarotes Licht kann alternativ auch ohne vorgeschalteten Infrarotfilter ausgebildet sein. In dieser besonders einfachen Variante wird zur Ermittlung der infraroten Lichtanteile ganz gezielt das Sensorelement für infrarotes Licht ausgelesen. Sofern eine Information nur über die sichtbaren Lichtanteile, das heißt blau, grün und rot, gewünscht ist, wird das in Einstrahlrichtung des Lichtes hinterste Sensorelement nicht angesteuert.

Der erfindungsgemäße Fotosensor mit hintereinander liegenden Sensorelementen weist somit nicht nur drei Sensorelemente für die blauen, grünen und roten Lichtanteile auf, sondern zudem eine weitere Schicht, welche soweit von der Oberfläche der Sensormatrix angeordnet ist, dass sie das nahinfrarote Licht absorbieren kann, das heißt einen Abstand zu der Oberfläche aufweist, welcher in etwa der Absorptionslänge der jeweiligen nahinfraroten Wellenlänge entspricht. Der Spektralbereich des nahen Infrarots umfasst im Wesentlichen den Bereich von 700 nm bis 3000 nm. Folglich wird das Sensorelement für die Absorption des nahinfraroten Lichtes so innerhalb der Sensormatrix positioniert und bemessen, dass im Wesentlichen Licht dieses Spektralbereiches absorbiert wird.

Zusätzlich zu den vorgenannten Varianten ist es möglich, in einzelnen Bereichen der Sensormatrix-Oberfläche Infrarot-Sperrfilter anzuordnen, beispielsweise auf einzelnen Pixeln, so dass gezielt Bereiche des Fotosensors geschaffen werden, in welche ausschließlich rotes, grünes und blaues Licht eindringen kann. Hierbei ist es denkbar, dass die mit einem Infrarot-Sperrfilter belegten Bereiche gemäß einer Streifen- oder Gitterstruktur über die Sensormatrix gelegt werden. Ebenso ist es jedoch auch denkbar, abhängig von der gewünschten verbleibenden Lichtintensität, dass die Pixel, welche nicht mit einem Infrarot-Sperrfilter versehen sind, die Streifen oder das Gitter auf der Sensormatrix bilden. Somit können auch bei diesem Typ des Fotosensors Blöcke aus ausschließlich rotes, grünes und blaues Licht detektierenden Pixeln gebildet werden, während es Bereiche gibt, beispielsweise Streifen, Gitter oder einzelne Pixel, welche neben dem roten, grünen und blauen Licht auch infrarotes Licht detektieren können.

Desweiteren sieht die Erfindung eine Vorrichtung zur Ermittlung einer Zutrittsberechtigung vor, welche den vorgenannten erfindungsgemäßen Fotosensor verwendet. Die Erfindung schlägt somit ebenfalls eine Vorrichtung zur Ermittlung einer Zutrittsberechtigung eines Nutzers und zum automatischen Öffnen eines Türschlosses vor, welche eine Vorrichtung zur optischen Gesichtsfelderkennung aufweist, die Lichtquellen zur Beleuchtung des Gesichtes des Nutzers mit sichtbarem und/oder infrarotem Licht und mindestens einen Fotosensor der vorgenannten, erfindungsgemäßen Art zum Empfang des von dem Gesicht reflektierten Lichtes aufweist, und mit einem Türschloss, wobei die Vorrichtung zur optischen Gesichtsfelderkennung zum Zwecke der Übertragung von Steuersignalen mit dem Türschloss verbunden ist, wobei das Türschloss einen elektronischen Schließzylinder aufweist und wobei ein Steuersignal der Vorrichtung zur optischen Gesichtsfelderkennung einen Befehl zur Aktivierung des Schließzylinders enthält.

Desweiteren wird die Verwendung eines Fotosensors beziehungsweise der vorgenannten Vorrichtung zur Ermittlung der Zutrittsberechtigung vorgeschlagen, wobei das biometrische Merkmal des Nutzers mittels der Vorrichtung zur optischen Gesichtsfelderkennung erfasst wird, das biometrische Merkmal mit individuumsbezogenen, gespeicherten Datensätzen für dieses Merkmal verglichen wird, die Vorrichtung zur optischen Gesichtsfelderkennung bei positivem Vergleichsergebnis bezüglich des Vorliegens der Zutrittsberechtigung ein Steuersignal an das Türschloss übermittelt, welches einen Befehl zur Aktivierung eines elektronischen Schließzylinders des Türschlosses aufweist, und wobei der elektronische Schließzylinder eine Stellung einnimmt, die eine Öffnung des Türschlosses ermöglicht.

Durch den Einsatz des erfindungsgemäßen Fotosensors kann die Vorrichtung zur Ermittlung einer Zutrittsberechtigung eines Nutzers bei unterschiedlichen Lichtbedingungen mit Erfolg verwendet werden. Sowohl bei einem Betrieb bei Tag als auch bei Nacht lassen sich somit gleichgute Detektionsergebnisse erzielen. Insbesondere lässt sich jedoch auch unabhängig von den Lichtbedingungen der Umgebung ein besonderer Modus für die Gesichtsfelderkennung nutzen, bei welchem das Gesicht des Nutzers mittels interner oder externer Lichtquellen mit sichtbarem und infrarotem Licht bestrahlt wird. Insbesondere durch die Kombination von Licht unterschiedlicher Wellenlängen, beispielsweise sowohl im sichtbaren als auch im infraroten Bereich, können kleinere und größere Merkmale des Gesichtes eines Nutzers mit gleicher Messgenauigkeit bestimmt werden. Aufgrund des unterschiedlichen Reflektionsgrades einzelner Zonen des Gesichtes in Bezug auf unterschiedliche Wellenlängen des Lichtes lassen sich Unterschiedsmerkmale vereinfacht feststellen. Besonders vorteilhaft ist dabei der Einsatz von LEDs, welche besonders kostengünstig sind und somit zu einer kostengünstigen Herstellung der gesamten Vorrichtung beitragen.

Um Zutritt zu einem bestimmten Bereich eines Gebäudes zu erlangen, stellt sich ein Nutzer in den Wirkungsbereich der Lichtquellen und des Fotosensors der Vorrichtung zur optischen Gesichtsfelderkennung. Die Vorrichtung registriert seine Anwesenheit und aktiviert die Lichtquellen, so dass das Gesicht des Nutzers mit sichtbarem und/oder infrarotem Licht bestrahlt wird. Das von dem Gesicht des Nutzers reflektierte Licht wird von dem Fotosensor der Vorrichtung zur optischen Gesichtsfelderkennung detektiert und einer Auswerteeinheit zugeführt.

Zusätzlich kann der Nutzer über einen Bildschirm zur Eingabe eines Identifikationscodes oder zur Vorlage einer Ausweiskarte aufgefordert werden. Dazu gibt der Nutzer über die Tastatur der Vorrichtung seinen Identifikationscode, welcher beispielsweise ein mehrstelliger Zahlencode sein kann, ein. Alternativ oder zusätzlich kann die Vorrichtung auch eine Chipkarte, einen USB-Stick oder einen aktiven oder passiven Transponder detektieren, wobei die darin gespeicherten Identifikationsdaten in die Vorrichtung zur optischen Gesichtsfelderkennung eingelesen werden. Anschließend werden die von der Tastatur, dem Datenleser beziehungsweise dem Fotosensor aufgenommenen Merkmale miteinander und mit individuumsbezogenen, in der Vorrichtung oder auf einen externen Speicher gespeicherten Datensätzen verglichen und im Falle eines positiven Vergleichsergebnisses bezüglich des Vorliegens der Zutrittsberechtigung bestätigt.

Bei positivem Auswerteergebnis sendet die Vorrichtung zur optischen Gesichtsfelderkennung ein Steuersignal an das Türschloss, welches einen Befehl zur Aktivierung des elektronischen Schließzylinders aufweist. Dieses Steuersignal wird besonders vorteilhaft per Funkübertragung an das Türschloss übermittelt, so dass keine Kabelverbindungen zwischen Türschloss und Vorrichtung zur optischen Gesichtsfelderkennung notwendig sind. Zusätzlich ist das Steuersignal verschlüsselt, so dass eine Abhörsicherheit in Bezug auf das übertragene Signal gegeben ist. Das Steuersignal wird von einer Empfangseinheit des Türschlosses erkannt und bewirkt einen Impuls, welcher auf den Schließzylinder des Türschlosses einwirkt. Der Schließriegel wird für den Öffnungsvorgang vollständig von der Schließposition in die Öffnungsposition überführt, so dass der Nutzer die Tür öffnen kann.

Üblicherweise werden bisher im Stand der Technik für die Gesichtsfelderkennung sogenannte RGB-Kameras mit üblichen Bayer-Sensoren verwendet. Derartige Bayer-Sensoren zerlegen ein Lichtsignal in die spektralen Bestandteile rot, grün und blau. Wie zuvor ausgeführt sind diese üblichen Bayer-Sensoren jedoch nicht geeignet, eine ausreichende Sicherheit bei der Gesichtsfelderkennung zu erzielen. Insbesondere ist eine zuverlässige Detektion und Gesichtsfelderkennung im Rahmen der Steuerung eines Schlosses für einen geschützten Bereich nicht zufriedenstellend. Die von den üblichen Bayer-Fotosensoren aufgezeichneten Bilder sind Schwankungen bei unterschiedlichen Lichtverhältnissen (insbesondere Tag/Nacht) ausgesetzt und zudem einfach manipulierbar, so dass die Sicherheitsanforderungen an eine Schlosssteuerung nicht erfüllt werden.

Im Rahmen der Erfindung wird nun ein Fotosensor vorgeschlagen, welcher neben den grünen, roten und blauen Spektralbereichen des Lichtes ebenfalls auch den Spektralbereich des nahen Infrarot, das heißt im Bereich von 700 nm bis 3000 nm, detektieren kann. In diesem Fall kann das Objekt, das heißt das Gesicht des Nutzers, mit Licht unterschiedlicher Wellenlängen im sichtbaren und infraroten Spektralbereich angestrahlt werden, während gleichzeitig die interessierenden spektralen Anteile ausgelesen werden. So ist es beispielsweise möglich, dass für einen Tagbetrieb der Kamera lediglich die sichtbaren Spektralanteile ausgewertet werden, während bei Nacht auf den Anteil des "nahen Infrarots" zurückgegriffen wird.

Erfindungsgemäß ist somit vorgesehen, dass lediglich ein einziger Fotosensor zum Einsatz kommt. Da Halbleitersensoren wie die sogenannten CCD-Sensoren beziehungsweise CMOS-Sensoren grundsätzlich sowohl zur Detektion von sichtbarem als auch infrarotem Licht geeignet sind, kann die Erfindung durch einen einzigen Fotosensor ausgeführt werden, ohne das zusätzlich ein Infrarotsensor erforderlich ist. Die Filtermatrix ist geeignet, nach Wunsch die grünen, roten und blauen Lichtbestandteile herauszufiltern und/oder alternativ auch das Infrarotlicht. Dies erfolgt mittels des Algorithmus, welcher die auszulesenden Pixel der Sensormatrix ansteuert. Sofern nur die Infrarotbestandteile des Lichtes von Interesse sind, werden lediglich die mit einem Infrarotfilter belegten Pixel der Sensormatrix ausgelesen, während bei anderen Anwendungsfällen zum Beispiel nur die Lichtbestandteile im sichtbaren Wellenlängenspektrum von Interesse sind und ausgelesen werden. So ist es beispielsweise denkbar, dass insbesondere bei einer Anwendung bei Nacht alle Pixel, das heißt sowohl die sichtbaren Bestandteile als auch die infraroten Bestandteil des Lichtes, ausgelesen werden, während für den Betrieb bei Tageslicht nur die Pixel, welche mit grünen, roten oder blauen Spektralfiltern belegt sind, angesteuert werden. Demgegenüber kann der Fotosensor bei Nacht so betrieben werden, dass lediglich die Pixel mit Infrarotfilter ausgelesen werden, so dass nur das Infrarotlicht ausgewertet wird. Dadurch kann ein mit Infrarotlicht bestrahltes Gesicht zuverlässig im Rahmen der optischen Gesichtsfelderkennung detektiert werden. Diese Vorgehensweise weist eine erhöhte Erkennungszuverlässigkeit zur Steuerung eines Türschlosses auf, so dass das System beispielsweise nicht mit Nachbildungen eines Gesichts oder dergleichen manipuliert werden kann. Bei der erfindungsgemäßen Vorrichtung ist vorgesehen, dass beispielsweise Merkmale unterhalb der Haut durch die entsprechende Infrarotbestrahlung des Gesichtes für den Fotosensor sichtbar gemacht werden und zur Steuerung des Schlosses genutzt werden können. Dabei wird berücksichtigt, dass beispielsweise Narben, Muttermale und so weiter eine andere Infrarotwellenlänge reflektieren als andere Hautstellen.

Insgesamt sind folgende drei Anwendungssituationen zu unterscheiden. Die genannten Betriebsarten sind dabei jedoch nicht beschränkend, sondern können selbstverständlich auch variiert werden, so dass auch bei abweichenden Tageszeiten oder Beleuchtungssituationen eine individuell anpassbare Detektion möglich ist.

Für den Nachtbetrieb des Fotosensors beziehungsweise der Vorrichtung zur optischen Gesichtsfelderkennung werden alle Pixel der Sensormatrix ausgelesen. Das heißt, es werden zur Auswertung des aufgenommenen Objektes sowohl die grünen, roten und blauen Lichtbestandteile als auch die Infrarotbestandteile herangezogen. Durch die Detektion von sowohl sichtbarem als auch infrarotem Licht kommt es zwar zu einer Farbverfälschung, diese ist jedoch für den Nachbetrieb nicht relevant ist. Wesentlich ist dabei eher, dass möglichst viel Licht auf den Fotosensor fällt.

Bei einem Tagbetrieb des Fotosensors beziehungsweise der Vorrichtung zur optischen Gesichtsfelderkennung werden nur diejenigen Pixel ausgelesen, welche grünes, rotes oder blaues Licht detektieren. Das Infrarotlicht trägt somit nicht zur Gesichtsfelderkennung bei. Dies ermöglicht vorteilhaft eine Detektion des Objektes in Echtfarben, so dass das von der Kamera detektierte Objekt dem vom menschlichen Auge wahrgenommenen Bild entspricht.

Desweiteren existiert ein besonderer Betriebsmodus des Fotosensors beziehungsweise der Vorrichtung zur optischen Gesichtsfelderkennung für die Gesichtserkennung mittels Infrarotlicht. Dabei werden lediglich die Pixel des Fotosensors vom Auslesealgorithmus angesteuert, welche einen Infrarotfilter aufweisen. Somit trägt nur das infrarote Licht zur Gesichtsfelderkennung bei. In dieser Betriebsweise können bevorzugt Merkmale unterhalb der Haut detektiert werden, die durch die Infrarotstrahlung für den Fotosensor sichtbar gemacht werden. Das ansonsten störende sichtbare Licht (rot, grün, blau) trägt nicht zur Detektion bei. Dieser Betriebsmodus ist auch beim Nachbetrieb des Fotosensors beziehungsweise der Vorrichtung zur optischen Gesichtsfelderkennung möglich.

Nach der Erfindung kann der verwendete Fotosensor unterschiedlich ausgebildet sein. Beispielhaft werden im Folgenden drei verschiedene Ausführungsformen näher beschrieben. Es zeigen:
- Fig. 1: eine Draufsicht eines erfindungsgemäßen Fotosensors mit einer Anordnung der Infrarotfilter in parallelen Zeilen;
- Fig. 2: eine Anordnung der Infrarotfilter in einer Gitterstruktur aus sich kreuzenden Zeilen und Spalten;
- Fig. 3: eine Anordnung der Infrarotfilter mit jeweils einem grünen, einem roten und einem blauen Spektralfilter innerhalb eines gemeinsamen Blockes;
- Fig. 4: ein Pixel eines weiteren erfindungsgemäßen Fotosensors in Schnittdarstellung;
- Fig. 5: eine Draufsicht auf einen Fotosensor mit Pixeln gemäß Fig. 4.

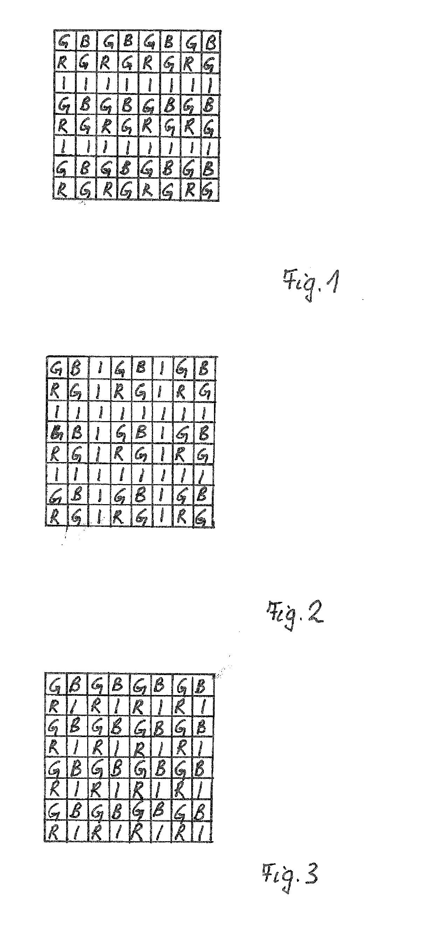

Der Fotosensor gemäß Fig. 1 weist im Wesentlichen drei gleichartige Blöcke auf, welche Spektralfilter für grünes, rotes und blaues Licht aufweisen. Die Spektralfilter für das grüne Licht sind dabei mit "G" bezeichnet. Die Spektralfilter für das blaue Licht sind mit "B" bezeichnet. Die Spektralfilter für das rote Licht sind mit "R" bezeichnet. Wie zu erkennen ist, weist jeder Block vier gleichartige Unterblöcke auf, die jeweils zwei grüne, einen roten und einen blauen Spektralfilter beinhalten. Zwischen jeweils zwei großen Blöcken ist eine Zeile mit Infrarotfiltern I angeordnet. Parallele Zeilen von Infrarotfiltern I finden sich gemäß diesem Ausführungsbeispiel in Zeile 3 und Zeile 6 des Fotosensors. Zum Betrieb dieses Fotosensors lediglich mit Infrarotlicht werden nur die Zeilen 3 und 6 des Fotosensors (von oben nach unten gelesen) ausgelesen. Die übrigen Zeilen, das heißt Zeilen 1, 2, 4, 5, 7 und 8, bleiben unberücksichtigt. Alternativ kann jedoch auch - beispielsweise für einen Tagbetrieb des Fotosensors - lediglich der Teil des Fotosensors ausgelesen werden, der von sichtbarem Licht beaufschlagt ist. Dies betrifft die Pixel, welche mit grünen, roten oder blauen Spektralfiltern G, R, B belegt sind. In einem weiteren Betriebsmodus des Fotosensors können alle Pixel ausgelesen werden, so dass sowohl die sichtbaren Spektralanteile als auch der infrarote Spektralanteil des Lichtes zur Detektion und somit auch zur Gesichtsfelderkennung beiträgt.

Der Fotosensor gemäß Fig. 2 zeigt Zeilen und Spalten von Infrarotfiltern I, welche gemäß einer Gitterstruktur angeordnet sind. Die Infrarotfilter belegen dabei die Zeilen 3 und 6 sowie die Spalten 3 und 6 vollständig. Die dazwischen liegenden jeweils vier Pixel sind - wie auch gemäß Fig. 1 - in der Form eines üblichen Bayer-Sensors ausgebildet, das heißt, diese weisen jeweils zwei grüne Spektralfilter G, einen roten Spektralfilter R und einen blauen Spektralfilter B auf. Wie zuvor dargestellt, kann auch dieser Fotosensor entsprechend der Ansteuerung mittels eines Algorithmus so ausgelesen werden, dass er den Beleuchtungs- und Umgebungsbedingungen des Fotosensors beziehungsweise der Vorrichtung zur optischen Gesichtsfelderkennung Rechnung trägt.

In dem Fotosensor gemäß Fig. 3 sind die Infrarotfilter unmittelbar in die Blöcke des zugrundeliegenden Bayer-Sensors eingearbeitet. Dabei bestehen die Blöcke aus jeweils vier Pixeln, wobei diese vier Pixel im Einzelnen einen grünen Spektralfilter G, einen roten Spektralfilter R, einen blauen Spektralfilter B und einen Infrarotfilter I aufweisen. Im Gegensatz zu einem Bayer-Sensor ist dabei ein grüner Spektralfilter G durch einen Infrarotfilter I ersetzt. Die Infrarotfilter I befinden sich somit nicht in separaten Zeilen und/oder Spalten, sondern sind unmittelbar in die Blöcke integriert.

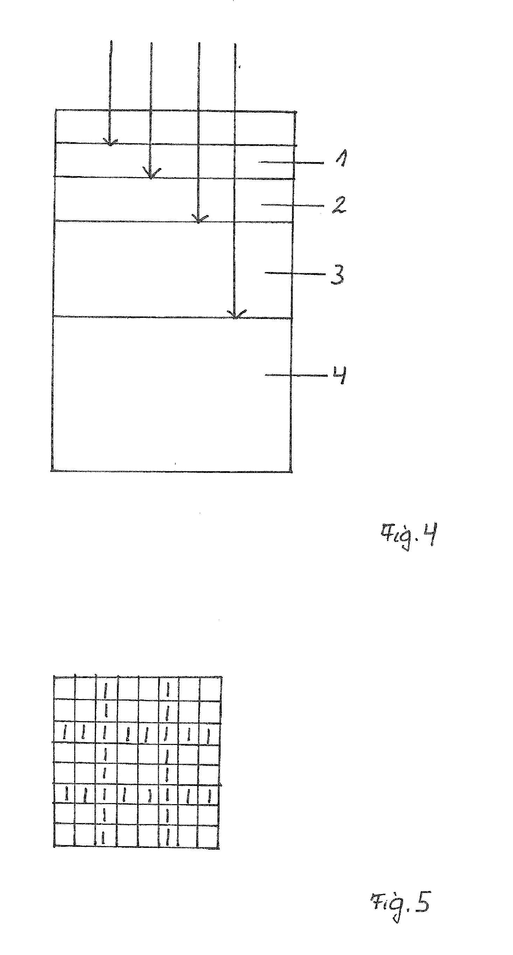

Die Figuren 4 und 5 zeigen im Querschnitt (Figur 4) sowie in Draufsicht (Figur 5) einen Fotosensor mit einer Sensormatrix aus lichtsensitiven Pixeln, wobei die Sensormatrix regelmäßig angeordnete Pixel mit mehreren in Strahlrichtung des Lichtes hintereinander angeordneten Sensorelementen 1, 2, 3, 4 aufweist.

Das im Schnitt dargestellte Pixel (Figur 4) verfügt über in Einstrahlrichtung des Lichtes hintereinander angeordnete Sensorelement 1, 2, 3, 4, welche jeweils selektiv Licht einer bestimmten Wellenlänge oder eines bestimmten Wellenlängenbereiches absorbieren. Die Sensorelemente 1, 2, 3, 4 sind dabei so innerhalb der Sensormatrix angeordnet, dass ihr jeweiliger Abstand zu der bestrahlten Oberfläche des Sensorelementes eine Größenordnung aufweist, welche mit der Absorptionslänge der jeweiligen Wellenlänge im Wesentlichen übereinstimmt. Das Sensorelement 1 dient dabei der Absorption des blauen Lichtanteils. Das Sensorelement 2 detektiert den grünen Lichtanteil. Das Sensorelement 3 detektiert den roten Lichtanteil. Das Sensorelement 4 schließlich detektiert Licht des nahinfraroten Spektralbereichs, bevorzugt zwischen 700 nm und 3000 nm. Sofern nun Licht mit Spektralanteilen sowohl im sichtbaren als auch im nahen Infrarotbereich auf ein solches Pixel fällt, wird die Lichtstrahlung mittels der hintereinander angeordneten Sensorelemente 1, 2, 3, 4 in seine Bestandteile Blau, Grün, Rot, nahes Infrarot aufgeteilt. Die dadurch entstehenden Ladungsteilströme in den einzelnen Sensorelementen 1, 2, 3, 4 sind ein Maß für den jeweiligen Lichtanteil.

Fig. 5 zeigt eine Draufsicht auf einen Fotosensor, welcher Pixel gemäß Fig. 4 nutzt. Die Sensormatrix besteht aus in Zeilen und Spalten angeordneten lichtsensitiven Pixeln. Einzelne der Pixel weisen zusätzlich Infrarotfilter I auf, welche eine Gitterstruktur aus sich kreuzenden Zeilen und Spalten bilden. Die mit Infrarotfiltern I belegten Pixel werden somit nur mit Licht blauen, roten und grünen Lichtanteils bestrahlt. Infrarotes Licht kann dagegen nicht in die Sensorelemente des Fotosensors eindringen. Die übrigen Bereiche des Fotosensors, welche nicht mit einem Infrarotfilter I belegt sind, werden demgegenüber mit Licht aller Spektralanteile bestrahlt. Dabei erfolgt die Aufspaltung des Lichts in seine Bestandteile wie gemäß Fig. 4 dargestellt. Für den Nachtbetrieb eines solchen Fotosensors werden vorteilhaft die nicht mit einem Infrarotfilter I belegten Pixel ausgelesen. Somit steht die gesamte Lichtintensität des nahinfraroten Lichtes für eine Auswertung zur Verfügung.

### Bezugszeichenliste

- 1: Sensorelement für blaues Licht
- 2: Sensorelement für grünes Licht
- 3: Sensorelement für rotes Licht
- 4: Sensorelement für infrarotes Licht
- B: Spektralfilter für blaues Licht
- G: Spektralfilter für grünes Licht
- R: Spektralfilter für rotes Licht
- I: Infrarotfilter

## Patentansprüche

1. Fotosensor mit einer Sensormatrix aus lichtsensitiven Pixeln, und mit einer in Einstrahlrichtung des Lichtes davor angeordneten Filtermatrix, welche zu den Pixeln der Sensormatrix korrespondierend angeordnete, jeweils entweder selektiv rotes, grünes oder blaues Licht transmittierende Spektralfilter (R, G, B) aufweist, und wobei die Spektralfilter (R, G, B) innerhalb der Filtermatrix ein wiederkehrendes Muster bilden,
**dadurch gekennzeichnet, dass**
die Filtermatrix zusätzlich Infrarotfilter (I) aufweist, welche so ausgebildet sind, dass sie infrarotes Licht transmittieren und gleichzeitig sichtbares Licht sperren.

2. Fotosensor nach Anspruch 1, **dadurch gekennzeichnet, dass** die jeweils entweder rotes, grünes oder blaues Licht transmittierenden Spektralfilter (R, G, B) im Wesentlichen regelmäßig so angeordnet sind, dass sie innerhalb der Filtermatrix wiederkehrende Blöcke bilden.

3. Fotosensor nach Anspruch 1 oder 2, **dadurch gekennzeichnet, dass** jeweils ein rotes Licht transmittierender Spektralfilter (R), zwei grünes Licht transmittierende Spektralfilter (G) und ein blaues Licht transmittierender Spektralfilter (B) zu einem Block angeordnet sind.

4. Fotosensor nach einem der vorhergehenden Ansprüche, **dadurch gekennzeichnet, dass** die Infrarotfilter (I) eine regelmäßige Anordnung innerhalb der Filtermatrix aufweisen.

5. Fotosensor nach Anspruch 4, **dadurch gekennzeichnet, dass** die Anordnung der Infrarotfilter (I) so ausgebildet ist, dass sie Blöcke aus rotes, grünes und blaues Licht transmittierenden Spektralfiltern (R, G, B) begrenzt.

6. Fotosensor nach Anspruch 4 oder 5, **dadurch gekennzeichnet, dass** die Anordnung der Infrarotfilter (I) eine Anordnung aus parallelen Zeilen oder Spalten aufweist.

7. Fotosensor nach einem der Ansprüche 4 bis 6, **dadurch gekennzeichnet, dass** die Anordnung der Infrarotfilter (I) eine Gitterstruktur aus sich kreuzenden Zeilen und Spalten aufweist.

8. Fotosensor nach Anspruch 1 oder 2, **dadurch gekennzeichnet, dass** jeweils ein rotes, ein grünes und ein blaues Licht transmittierender Spektralfilter (R, G, B) sowie ein Infrarotfilter (I) zu einem Block angeordnet sind.

9. Fotosensor mit einer Sensormatrix aus lichtsensitiven Pixeln, wobei die Sensormatrix mehrere in Einstrahlrichtung des Lichtes hintereinander angeordnete Sensorelemente aufweist, welche jeweils entweder selektiv blaues, grünes oder rotes Licht absorbieren, wobei die Sensorelemente innerhalb der Sensormatrix mit einem Abstand zu der bestrahlten Oberfläche angeordnet sind, welcher im wesentlichen der Absorptionslänge der jeweiligen Lichtwellenlänge entspricht, **dadurch gekennzeichnet,**
**dass** in Einstrahlrichtung des Lichtes vor der Sensormatrix eine Filtermatrix angeordnet ist, welche zu einer Teilmenge von Pixeln der Sensormatrix korrespondierend angeordnete Infrarotfilter (I) aufweist, welche so ausgebildet sind, dass sie infrarotes Licht transmittieren und gleichzeitig sichtbares Licht sperren.

10. Fotosensor nach Anspruch 9, **dadurch gekennzeichnet, dass** die Sensormatrix in Einstrahlrichtung hinter den blaues, grünes und rotes Licht absorbierenden Sensorelementen ein zusätzliches Sensorelement
aufweist, welches infrarotes Licht absorbiert, wobei das infrarotes Licht absorbierende Sensorelement mit einem Abstand zu der bestrahlten Oberfläche angeordnet ist, welcher im Wesentlichen der Absorptionslänge der Lichtwellenlängen des nahinfraroten Spektralbereichs entspricht.

11. Vorrichtung zur Ermittlung einer Zutrittsberechtigung eines Nutzers und zum automatischen Öffnen eines Türschlosses, mit einer Vorrichtung zur optischen Gesichtsfelderkennung, welche Lichtquellen zur Beleuchtung des Gesichtes des Nutzers mit sichtbarem und/oder infrarotem Licht und mindestens einen Fotosensor nach einem der Ansprüche 1 bis 8 zum Empfang des von dem Gesicht reflektierten Lichtes aufweist, und mit einem Türschloss, wobei die Vorrichtung zur optischen Gesichtsfelderkennung zum Zwecke der Übertragung von Steuersignalen mit dem Türschloss verbunden ist, wobei das Türschloss einen elektronischen Schließzylinder aufweist, und wobei ein Steuersignal der Vorrichtung zur optischen Gesichtsfelderkennung einen Befehl zur Aktivierung des Schließzylinders enthält.

12. Vorrichtung nach Anspruch 11, **dadurch gekennzeichnet, dass** die Vorrichtung zur optischen Gesichtsfelderkennung mittels einer Funkverbindung mit dem Türschloss verbunden ist.

13. Vorrichtung nach einem der Ansprüche 11 oder 12, **gekennzeichnet durch** einen Datenleser oder einen aktiven oder passiven Transponderempfänger.

14. Verwendung eines Fotosensors bzw. einer Vorrichtung nach einem der Ansprüche 1 bis 13 für die Ermittlung einer Zutrittsberechtigung eines Nutzers für einen bestimmten Bereich eines Gebäudes und zum automatischen Öffnen eines Türschlosses, unter Verwendung wenigstens eines biometrischen Merkmals, wobei
- das biometrische Merkmal mittels einer Vorrichtung zur optischen Gesichtsfelderkennung erfasst wird,
- das biometrische Merkmal mit individuumsbezogenen, gespeicherten Datensätzen für dieses Merkmal verglichen wird,
- die Vorrichtung zur optischen Gesichtsfelderkennung bei positivem Vergleichsergebnis bezüglich des Vorliegens der Zutrittsberechtigung ein Steuersignal an das Türschloss übermittelt, welches einen Befehl zur Aktivierung eines elektronischen Schließzylinders des Türschlosses aufweist, und wobei
- der elektronische Schließzylinder eine Stellung einnimmt, die eine Öffnung des Türschlosses ermöglicht.

15. Verwendung nach Anspruch 14, **dadurch gekennzeichnet, dass** der Nutzer zusätzlich eine Eingabe über eine Schnittstelle der Vorrichtung zur optischen Gesichtsfelderkennung tätigt, wobei das biometrische Merkmal des Nutzers mit dem Inhalt der Eingabe verglichen wird.

16. Verwendung nach Anspruch 14 oder 15, **dadurch gekennzeichnet, dass** die Vorrichtung zur optischen Gesichtsfelderkennung Licht mittels interner oder externer Lichtquellen, insbesondere mittels LEDs, emittiert.

## Geänderte Patentansprüche

### Geänderte Patentansprüche gemäss Regel 137(2) EPÜ.

**1.** Vorrichtung zur Ermittlung einer Zutrittsberechtigung eines Nutzers und zum automatischen Öffnen eines Türschlosses, mit einer Vorrichtung zur optischen Gesichtsfelderkennung, welche Lichtquellen zur Beleuchtung des Gesichtes des Nutzers mit sichtbarem und infrarotem Licht und mindestens einen Fotosensor zum Empfang des von dem Gesicht reflektierten Lichtes aufweist, und mit einem Türschloss, wobei die Vorrichtung zur optischen Gesichtsfelderkennung zum Zwecke der Übertragung von Steuersignalen mit dem Türschloss verbunden ist, wobei das Türschloss einen elektronischen Schließzylinder aufweist, und wobei ein Steuersignal der Vorrichtung zur optischen Gesichtsfelderkennung einen Befehl zur Aktivierung des Schließzylinders enthält,
**dadurch gekennzeichnet,**
**dass** der Fotosensor eine Sensormatrix aus lichtsensiven Pixeln und eine in Einstrahlrichtung des Lichtes davor angeordnete Filtermatrix aufweist, welche Filtermatrix zu den Pixeln der Sensormatrix korrespondierend angeordnete, jeweils entweder selektiv rotes oder grünes oder blaues Licht transmittierende Spektralfilter (R, G, B) aufweist, und wobei die Spektralfilter (R, G, B) innerhalb der Fitermatrix ein wiederkehrendes Muster bilden.

**2.** Vorrichtung nach Anspruch 1, **dadurch gekennzeichnet, dass** die Filtermatrix zusätzlich Infrarotfilter (I) aufweist, welche so ausgebildet sind, dass sie infrarotes Licht transmittieren und gleichzeitig sichtbares Licht sperren.

**3.** Vorrichtung zur Ermittlung einer Zutrittsberechtigung eines Nutzers und zum automatischen Öffnen eines Türschlosses, mit einer Vorrichtung zur optischen Gesichtsfelderkennung, welche Lichtquellen zur Beleuchtung des Gesichtes des Nutzers mit sichtbarem und infrarotem Licht und mindestens einen Fotosensor zum Empfang des von dem Gesicht reflektierten Lichtes aufweist, und mit einem Türschloss, wobei die Vorrichtung zur optischen Gesichtsfelderkennung zum Zwecke der Übertragung von Steuersignalen mit dem Türschloss verbunden ist, wobei das Türschloss einen elektronischen Schließzylinder aufweist, und wobei ein Steuersignal der Vorrichtung zur optischen Gesichtsfelderkennung einen Befehl zur Aktivierung des Schließzylinders enthält,
**dadurch gekennzeichnet,**
**dass** der Fotosensor eine Sensormatrix aus lichtsensitiven Pixeln aufweist, wobei die Sensormatrix mehrere in Einstrahlrichtung des Lichtes hintereinander angeordnete Sensorelemente aufweist, welche jeweils entweder selektiv blaues oder grünes oder rotes Licht absorbieren, wobei die Sensorelemente innerhalb der Sensormatrix mit einem Abstand zu der bestrahlten Oberfläche angeordnet sind, welcher im wesentlichen der Absorptionslänge der jeweiligen Lichtwellenlänge entspricht.

**4.** Vorrichtung nach Anspruch 3, **dadurch gekennzeichnet, dass** in Einstrahlrichtung des Lichtes vor der Sensormatrix eine Filtermatrix angeordnet ist, welche zu einer Teilmenge von Pixeln der Sensormatrix korrespondierend angeordnete Infrarotfilter (I) aufweist, welche so ausgebildet sind, dass sie infrarotes Licht transmittieren und gleichzeitig sichtbares Licht sperren.

**5.** Vorrichtung nach einem der vorhergehenden Ansprüche, **dadurch gekennzeichnet, dass** die Vorrichtung zur optischen Gesichtsfelderkennung mittels einer Funkverbindung mit dem Türschloss verbunden ist.

**6.** Vorrichtung nach einem der vorhergehenden Ansprüche, **gekennzeichnet durch** einen Datenleser oder einen aktiven oder passiven Transponderempfänger.

**7.** Verwendung einer Vorrichtung nach einem der Ansprüche 1 bis 6 für die Ermittlung einer Zutrittsberechtigung eines Nutzers für einen bestimmten Bereich eines Gebäudes und zum automatischen Öffnen eines Türschlosses, unter Verwendung wenigstens eines biometrischen Merkmals, wobei
- das biometrische Merkmal mittels der Vorrichtung zur optischen Gesichtsfelderkennung erfasst wird,
- das biometrische Merkmal mit individuumsbezogenen, gespeicherten Datensätzen für dieses Merkmal verglichen wird,
- die Vorrichtung zur optischen Gesichtsfelderkennung bei positivem Vergleichsergebnis bezüglich des Vorliegens der Zutrittsberechtigung ein Steuersignal an das Türschloss übermittelt, welches einen Befehl zur Aktivierung eines elektronischen Schließzylinders des Türschlosses aufweist, und wobei
- der elektronische Schließzylinder eine Stellung einnimmt, die eine Öffnung des Türschlosses ermöglicht.

**8.** Verwendung nach Anspruch 7, **dadurch gekennzeichnet, dass** der Nutzer zusätzlich eine Eingabe über eine Schnittstelle der Vorrichtung zur optischen Gesichtsfelderkennung tätigt, wobei das biometrische Merkmal des Nutzers mit dem Inhalt der Eingabe verglichen wird.

**9.** Verwendung nach Anspruch 7 oder 8, **dadurch gekennzeichnet, dass** die Vorrichtung zur optischen Gesichtsfelderkennung Licht mittels interner oder externer Lichtquellen, insbesondere mittels LEDs, emittiert.

**10.** Verwendung nach einem der Ansprüche 7 bis 9, **dadurch gekennzeichnet, dass** die Pixel abhängig von den Lichtbedingungen der Umgebung so angesteuert werden, dass entweder lediglich die detektierten grünen, roten und blauen Lichtbestandteile ausgelesen werden, oder nur die infraroten Lichtbestandteile ausgelesen werden.

**11.** Verwendung nach einem der Ansprüche 7 bis 9, **dadurch gekennzeichnet, dass** unabhängig von den Lichtbedingungen der Umgebung sowohl die detektierten grünen, roten und blauen Lichtbestandteile als auch die detektierten infraroten Lichtbestandteile ausgelesen werden.
